# EUROPEAN PATENT APPLICATION

(11) **EP 1 466 699 A1**
(43) Date of publication of application: **13.10.2004**
(21) Application number: 04008453.5
(22) Date of filing: 07.04.2004
(51) Int. Cl.: B24B 37/04, B24D 18/00

(54) **Abrasive pad, method and metal mold for manufacturing the same, and semiconductor wafer polishing method**

(30) Priority: 09.04.2003 JP 2003105924
(71) Applicant: JSR Corporation, Tokyo 104-0045 (JP)
(72) Inventor: Hosaka, Yukio, Tokyo 104-0045 (JP); Shiho, Hiroshi, Tokyo 104-0045 (JP); Hasegawa, Kou, Tokyo 104-0045 (JP); Kawahashi, Nobuo, Tokyo 104-0045 (JP)
(74) Representative: Leson, Thomas Johannes Alois, Dipl.-Ing.

(57) **Abstract**

An abrasive pad (1) capable of transmitting light for end point detection without reducing polishing efficiency in the polishing of a semiconductor wafer using an optical end-point detection device, method of manufacturing the abrasive pad, a metal mold (7) for manufacturing the abrasive pad, and a method of polishing a semiconductor wafer.

This abrasive pad (1) comprises an abrasive substrate (11) and a light transmitting member (12). The light transmitting member (12) comprises a crosslinked polymer such as crosslinked 1,2-polybutadiene and a water-soluble substance such as β-cyclodextrin dispersed in the crosslinked polymer. Since the light transmitting member (12) and the abrasive substrate (11) are fused together as an integrated unit, slurry does not leak to the rear side of the abrasive pad during the abrasive pad used. This manufacturing method comprises setting the light transmitting member (12) in the metal mold (7) for insert molding and crosslinking a matrix dispersion for forming the abrasive substrate in this mold. The polishing method using this abrasive pad employs an optical end-point detection device.

## Description

### Field of the Invention

The present invention relates to an abrasive pad, a method and a metal mold for manufacturing the same, and a semiconductor wafer polishing method.

More specifically, it relates to an abrasive pad which can transmit light without reducing polishing efficiency, a method of manufacturing the abrasive pad, a metal mold for manufacturing the abrasive pad, an abrasive laminated pad which can transmit light, and a semiconductor wafer polishing method.

The present invention is used to polish a semiconductor wafer, making use of an optical end-point detection device.

### Description of the Prior Art

In the polishing of a semiconductor wafer, after the purpose of polishing is accomplished, the decision of the polishing end point for terminating polishing can be made based on a time obtained empirically. However, various materials are used to form surfaces to be polished and polishing time differs by each material. It is conceivable that the material forming the surface to be polished will change in the future. Further, the same can be said of slurry used for polishing and a polishing machine. Therefore, it is extremely inefficient to obtain empirically the each polishing time from the various polishings. To cope with this, research into optical end-point detection device and process using an optical method capable of directly observing the state of the surface to be polished is now under way (JP-A 9-7985, JP-A 2000-326220 and JP-A 11-512977) (the term "JP-A" as used herein means an "unexamined published Japanese patent application").

In the optical end-point detection device and process, a window which is made from a hard and homogeneous resin capable of transmitting light for end-point detection and has substantially no ability to absorb and carry a slurry substance is generally formed in an abrasive pad, and the surface to be polished is observed only from this window (JP-A 11-512977).

However, since the window has substantially no ability to hold and discharge slurry in the above abrasive pad, it is apprehended that the polishing efficiency of the abrasive pad may be reduced or become nonuniform by forming the window. Therefore, it is difficult to form a large ring window or to increase the number of windows.

### Summary of the Invention

It is an object of the present invention which has solved the above problem to provide an abrasive pad which can transmit light for end-point detection without reducing polishing efficiency in the polishing of a semiconductor wafer, a method of manufacturing the abrasive pad, a metal mold for manufacturing the abrasive pad, an abrasive laminated pad, and a semiconductor wafer polishing method.

Other objects and advantages of the present invention will become apparent from the following description.

The inventors of the present invention have studied an abrasive pad used for polishing, making use of an optical end-point detection device, and have found that when a light transmitting member having light transmission properties is used as a window in place of a prior art window made from a hard and homogeneous resin which has no ability to hold and discharge slurry, satisfactory light transmission properties can be ensured and further that the polishing end point can be detected. They have also found that when a water-soluble substance is dispersed and contained in the matrix material of the window, the window is provided with the ability to hold and discharge slurry at the time of polishing. Further, they have discovered that slurry does not leak from the polishing surface when an abrasive substrate and a light transmitting member are fused and fixed together.

That is, according to the present invention, firstly, the above objects and advantages of the present invention are attained by an abrasive pad comprising an abrasive substrate having a polishing surface and a light transmitting member which is fused to the abrasive substrate and comprises a water-insoluble matrix material and a water-soluble substance dispersed in the water-insoluble matrix material.

According to the present invention, secondly, the above objects and advantages of the present invention are attained by a method of manufacturing the abrasive pad of the present invention, comprising holding a previously formed light transmitting member for an abrasive pad at a predetermined position in the cavity of a metal mold for insert molding and injecting the material of an abrasive substrate into the remaining space in the cavity to fuse the light transmitting member to the abrasive substrate.

According to the present invention, thirdly, the above objects and advantages of the present invention are attained by a method of manufacturing the abrasive pad of the present invention, comprising holding a previously formed abrasive substrate having a hole for accepting a light transmitting member in the cavity of a metal mold for insert molding and injecting the material of the light transmitting member into the hole for accepting the light transmitting member to fuse the abrasive substrate to the light transmitting member.

According to the present invention, in the fourth place, the above objects and advantages of the present invention are attained by a metal mold for insert molding for the manufacture of the abrasive pad of the present invention, which has a projection portion(s) and/or a depressed portion(s) for holding a light transmitting member or an abrasive substrate for an abrasive pad in a cavity.

According to the present invention, in the fifth place, the above objects and advantages of the present invention are attained by an abrasive laminated pad comprising the abrasive pad of the present invention and a base layer having light transmission properties formed on the rear surface opposite to the polishing surface of the abrasive pad.

According to the present invention, in the sixth place, the above objects and advantages of the present invention are attained by an abrasive laminated pad comprising the abrasive pad of the present invention, a base layer formed on the rear surface opposite to the polishing surface of the abrasive pad, and a fixing layer for fixing the pad on a polishing machine, formed on the side opposite to the abrasive pad of the base layer.

According to the present invention, finally, the above objects and advantages of the present invention are attained by a method of polishing a semiconductor wafer with an abrasive pad, characterized in that the abrasive pad or the abrasive laminated pad of the present invention is used, and the polishing end point of the semiconductor wafer is detected by an optical end-point detection device through the light transmitting member of the abrasive pad or the abrasive laminated pad.

### Brief Description of the Drawings

Fig. 1 is a schematic diagram showing the shapes and fusion state of an abrasive substrate and a light transmitting member;
Fig. 2 is a schematic diagram showing the shapes and fusion state of an abrasive substrate and a light transmitting member;
Fig. 3 is a schematic diagram showing the shapes and fusion state of an abrasive substrate and a light transmitting member;
Fig. 4 is a schematic diagram showing the shapes and fusion state of an abrasive substrate and a light transmitting member;
Fig. 5 is a schematic diagram showing the shapes and fusion state of an abrasive substrate and a light transmitting member;
Fig. 6 is a schematic diagram showing the shapes and fusion state of an abrasive substrate and a light transmitting member;
Fig. 7 is a schematic diagram showing the shapes and fusion state of an abrasive substrate and a light transmitting member;
Fig. 8 is a schematic diagram showing the shapes and fusion state of an abrasive substrate and a light transmitting member;
Fig. 9 is a plan view of an example of the abrasive pad of the present invention;
Fig. 10 is a plan view of another example of the abrasive pad of the present invention;
Fig. 11 is a plan view of still another example of the abrasive pad of the present invention;
Fig. 12 is a partial sectional view of a metal mold for molding the abrasive pad of the present invention;
Fig. 13 is a sectional view showing that a light transmitting member is fixed in a metal mold for molding an abrasive pad;
Fig. 14 is a sectional view showing that an abrasive substrate dispersion is injected into a metal mold for molding an abrasive pad, having a light transmitting member fixed therein;
Fig. 15 is a sectional view of the abrasive pad of the present invention;
Fig. 16 is a partial sectional view of a metal mold having a projection portion of the present invention;
Fig. 17 is a sectional view showing that an abrasive substrate is fixed in a metal mold for molding an abrasive pad, having a projection portion;
Fig. 18 is a sectional view showing that a light transmitting member dispersion is injected into a metal mold for molding an abrasive pad, having an abrasive substrate fixed therein;
Fig. 19 is a partial sectional view of a metal mold having a depressed portion;
Fig. 20 is a sectional view showing that an abrasive substrate dispersion is injected into a metal mold for molding an abrasive pad, having a light transmitting member fixed therein;
Fig. 21 is a diagram of the abrasive pad of the present invention;
Fig. 22 is a diagram of an abrasive pad having fixing layers;
Fig. 23 is a diagram of an abrasive pad having a base layer;
Fig. 24 is a diagram of an abrasive pad having a base layer and fixing layers;
Fig. 25 is a diagram for explaining a polishing method using the abrasive pad or abrasive laminated pad of the present invention; and
Fig. 26 is a sectional view of a material to be polished suitably by the polishing method of the present invention.
Fig. 27 is a diagram for showing a position of a through hole formed to an abrasive pad substrate in Examples 4 to 7.

### Detailed Description of the Preferred Embodiments

The present invention will be described in detail hereinunder.

### Abrasive pad

The abrasive pad of the present invention comprises an abrasive substrate and a light transmitting member.

### Abrasive substrate

The abrasive substrate can hold slurry on the surface and can retain the residual dust after polishing temporarily. It doesn't matter whether this abrasive substrate has light transmission properties or not. The planar shape of the abrasive substrate is not particularly limited and may be circular or polygonal (quadrilateral, etc.). The size of the abrasive substrate is not particularly limited as well.

Preferably, slurry can be held during polishing and the residual dust can be retained temporarily on the surface of this abrasive substrate. Therefore, the abrasive substrate may have at least one member selected from minute holes (to be referred to as "pores" hereinafter), grooves and fluff formed by dressing. They may be formed in advance or formed at the time of polishing. That is, the abrasive substrate is selected from (1) an abrasive substrate which comprises a water-insoluble matrix material and a water-soluble substance dispersed in the water-insoluble matrix material, (2) an abrasive substrate (foamed material) which comprises a water-insoluble matrix material and pores dispersed in the water-insoluble matrix material, and (3) an abrasive substrate which consists only of a water-insoluble matrix (non-foamed material) and can be fluffed by dressing.

The material of the water-insoluble matrix in the above abrasive substrates (1) to (3) is not particularly limited and various materials may be used. It is preferably an organic material because it can be easily molded to have a predetermined shape or properties and can be provided with suitable elasticity. As the organic material may be used various materials which are suitably used as the matrix material of the abrasive substrate to be described hereinafter.

The materials for forming the abrasive substrate may be the same or different in type from the materials for forming the light transmitting member. An abrasive substrate made from materials different in type from the materials for forming the light transmitting member or an abrasive substrate made from materials which are the same in type but different in ratio from the materials for forming the light transmitting member is preferably used.

To prevent the light transmitting member from projecting or depressing at the time of polishing, it is preferred that the abrasion resistance of the abrasive substrate should not greatly differ from that of the light transmitting member.

As the above "water-insoluble matrix material" (may also simply referred to as "matrix material" hereinafter), a thermoplastic resin, thermosetting resin, elastomer and rubber are preferably used alone or in combination.

Examples of the above thermoplastic resin include polyolefin resin, polystyrene resin, polyacrylic resin such as {(meth)acrylate resin}, vinyl ester resin (excluding acrylic resin), polyester resin, polyamide resin, fluororesin, polycarbonate resin and polyacetal resin.

Examples of the above thermosetting resin include phenolic resin, epoxy resin, unsaturated polyester resin, polyurethane resin, polyurethane-urea resin, urea resin and silicon resin.

Examples of the above elastomer include styrene elastomers such as styrene-butadiene-styrene block copolymer (SBS) and hydrogenated block copolymer thereof (SEBS); thermoplastic elastomers such as polyolefin elastomer (TPO), thermoplastic polyurethane elastomer (TPU), thermoplastic polyester elastomer (TPEE), polyamide elastomer (TPAE) and diene elastomer (such as 1,2-polybutadiene); silicone resin elastomer and fluororesin elastomer.

Examples of the above rubber include butadiene rubber, styrene·butadiene rubber, isoprene rubber, isobutylene·isoprene rubber, acrylic rubber, acrylonitrile·butadiene rubber, ethylene·propylene rubber, ethylene·propylene·diene rubber, silicone rubber and fluorine rubber.

The matrix material may be a crosslinked polymer or noncrosslinked polymer. At least part of the matrix material is preferably a crosslinked polymer. For example, the matrix material is a mixture of two or more materials and at least part of at least one of the materials is a crosslinked polymer, or the matrix material is only one material and at least part of the material is a crosslinked polymer.

When at least part of the matrix material has a crosslinked structure, elastic recovery force can be provided to the matrix material. Therefore, it is possible to suppress displacement caused by shearing stress applied to the abrasive pad at the time of polishing and to prevent the pores from being filled by the plastic deformation of the matrix material when it is excessively stretched at the time of polishing and dressing. It is also possible to prevent the surface of the abrasive pad from being fluffed excessively. Consequently, the retainability of slurry at the time of polishing is high, the retainability of slurry is easily recovered by dressing, and further scratching can be prevented.

Examples of the above crosslinked polymer include polymers obtained by crosslinking resins such as polyurethane resin, epoxy resin, polyacrylic resin, unsaturated polyester resin and vinyl ester resin (excluding polyacrylic resin), diene-based elastomer (1,2-polybutadiene), butadiene rubber, isoprene rubber, acrylic rubber, acrylonitrile-butadiene rubber, styrene-butadiene rubber, ethylene-propylene rubber, silicone rubber, fluorine rubber and styrene-isoprene rubber, out of the above thermoplastic resins, thermosetting resins, elastomers and rubbers, and polymers obtained by crosslinking polyethylene or polyvinylidene fluoride in the presence of a crosslinking agent or through exposure to ultraviolet radiation or electron beam. Ionomers may also be used.

These matrix materials may be used in combination of two or more.

Further, polymers modified by at least one hydrophilic functional group such as acid anhydride group, carboxyl group, hydroxyl group, epoxy group or amino group to improve hydrophilic nature with slurry may be used as the matrix material.

Examples of the above matrix material include polymers such as maleic anhydride modified polyethylene, maleic anhydride modified polypropylene, polybutadiene having a terminal hydroxyl group and polybutadiene having a terminal carboxyl group; and polymers and copolymers obtained by polymerizing a monomer having the above functional group. Polybutadiene having a terminal hydroxyl group and polybutadiene having a terminal carboxyl group are particularly preferred. They may be used alone or in combination of two or more.

Further, the matrix material may be a mixture of a polymer having any one of the above functional groups and a polymer having none of the above functional groups.

The above "modification" may be carried out, for example, by (a) a method in which a polymer is heated in the presence of a monomer having an acid anhydride group and a peroxide (hydrogen peroxide, organic peroxide, etc.) to add a side chain having an acid anhydride structure to a polymer having no acid anhydride structure in the main chain, or (b) a method in which a polymer is heated in the presence of a compound having at least two acid anhydride structures in the molecular and/or a compound having an acid anhydride structure and a carboxyl group in the molecular and a catalyst such as an acidic, alkali or metal catalyst to add a side chain having an acid anhydride structure to a polymer having no acid anhydride structure in the main chain.

Examples of the monomer having an acid anhydride structure used in the method (a) include maleic anhydride, itaconic anhydride, citraconic anhydride and endomethylenetetrahydrophthalic anhydride.

Examples of the compound having at least two acid anhydride structures in the molecule used in the method (b) include pyromellitic anhydride and 3,3',4,4'-benzophenonetetracarboxyilc dianhydride; and examples of the compound having an acid anhydride structure and carboxyl group in the molecule include trimellitic anhydride.

The member constituting the above abrasive substrate may further comprise a water-soluble substance.

This water-soluble substance can form pores for holding slurry for polishing by separating from the surface of the matrix material when it contacts water. The average diameter of the pores formed after the water-soluble substance separates from the abrasive pad, that is, the average diameter of the water-soluble substance contained in the matrix before it is eliminated may be 0.1 to 500 µm, preferably 0.5 to 100 µm, more preferably 5 to 50 µm.

The water-soluble substance includes what can be liberated when it is gelled by contact to water, such as water absorbing resins, in addition to water-soluble substances such as water-soluble polymers. This water-soluble substance may dissolve or gel in a medium containing water as the main ingredient and methanol or the like. The water-soluble substance is generally dispersed in the matrix material.

The water-soluble substance is often solid but may be liquid. The solid water-soluble substance is generally particulate but may be fibrous such as whisker-shaped, other linear-shaped, or odd-shaped such as tetrapod-shaped. The water-soluble substance is preferably particulate, more preferably solid particulate so that it can retain its shape even at a thermal kneading temperature.

The average particle diameter of the water-soluble particles may be 0.1 to 500 µm, preferably 0.5 to 100 µm, more preferably 5 to 50 µm. When this average particle diameter is smaller than 0.1 µm, the formed pores are small and an abrasive pad capable of holding abrasive grains completely may not be obtained. When the average particle diameter is larger than 500 µm, the mechanical strength of the obtained abrasive pad may lower. The average particle diameter is the average value of maximum lengths of the water-soluble particles contained in the matrix.

The water-soluble substance may be inorganic or organic. Out of these, it is preferably organic.

Examples of the organic water-soluble substance include dextrin, cyclodextrin, mannitol, saccharides such as lactose, celluloses such as hydroxypropyl cellulose and methyl cellulose, starch, protein, polyvinyl alcohol, polyvinyl pyrrolidone, polyvinylsulfonic acid, polyacrylic acid, polyethylene oxide, water-soluble photosensitive resin and sulfonated polyisoprene. They may be used alone or in admixture of two or more.

Examples of the inorganic water-soluble substance include potassium acetate, potassium nitrate, potassium carbonate, potassium hydrogencarbonate, potassium bromide, potassium phosphate, potassium sulfate, magnesium sulfate and calcium nitrate. They may be used alone or in admixture of two or more.

The liquid water-soluble substance is not limited to a particular type but preferably what does not have a bad influence upon polishing efficiency when it dissolves in slurry during use. The liquid water-soluble substance includes a water-soluble substance which is liquid itself and also a water-soluble substance which is not liquid but solid at normal temperature and dissolves in water to become an aqueous solution. Examples of the liquid water-soluble substance include organic acids such as formic acid, acetic acid, an aqueous solution of tartaric acid, aqueous solution of succinic acid and aqueous solution of malonic acid, and oxidizing agents such as aqueous solution of hydrogen peroxide, aqueous solution of peracetic acid and nitric acid.

When the water-soluble substance is contained in the water-insoluble matrix material, it is dispersed in the entire matrix material. Pores are formed in an abrasive pad comprising the matrix containing this water-soluble substance by the dissolution of the water-soluble substance existent on the most surface layer of the abrasive pad through contact to water. The pores have the function of holding slurry and retaining the residual dust after polishing temporarily. The water-soluble substance dissolves or gels when it contacts slurry which is an aqueous dispersion contained in the abrasive pad and separates from the matrix material.

Preferably, the water-soluble substance dissolves or gels in water only when it is exposed to the surface layer of the abrasive pad and does not absorb moisture or gel in the abrasive pad. Therefore, the water-soluble substance preferably has an outer shell for suppressing moisture absorption on at least part of its outer surface. This outer shell may be physically adsorbed to or chemically bonded to the water-soluble substance, or may be in contact with the water-soluble substance by physical adsorption or chemical bonding. Examples of the material forming this outer shell include epoxy resin, polyimide, polyamide and polysilicate. Even when this outer shell is formed only on part of the water-soluble substance, the above effect can be fully obtained.

This water-soluble substance in the abrasive pad has the function of increasing the indentation hardness of the abrasive pad (to 35 to 100 in terms of Shore D hardness) in addition to the above function of forming pores. As this indentation hardness is high, pressure applied to the surface to be polished by the abrasive pad can be increased. Therefore, not only the polishing rate can be improved but also high polishing flatness can be obtained. Accordingly, this water-soluble substance is particularly preferably a solid material which can secure sufficiently high indentation hardness for the abrasive pad.

The content of the water-soluble substance in this abrasive substrate is preferably 90 vol% or less, more preferably 80 vol% or less, much more preferably 0.1 to 80 vol%, particularly preferably 1 to 50 vol%, ideally 1 to 30 vol% based on 100 vol% of the total of the water-insoluble matrix material and the water-soluble substance. When the content of the water-soluble substance is higher than 90 vol%, it may be difficult to completely prevent the water-soluble substance contained in the matrix material from being gelled or dissolved one after another and therefore to maintain the hardness and mechanical strength of the abrasive pad at appropriate values.

The method of dispersing the above hydrophilic substance and the water-soluble substance into the matrix material at the time of production is not particularly limited. For instance, the matrix material, hydrophilic substance and water-soluble substance and optionally other additives are kneaded together to obtain a dispersion. The shape of the obtained dispersion is not particularly limited. For example, it is obtained in the form of a pellet, crumb or powder. The matrix material is preferably kneaded under heating so that it can be easily processed. At this heating temperature, the hydrophilic substance and the water-soluble substance are preferably solid.

When they are solid, the hydrophilic substance is easily dispersed though it has compatibility with the matrix material and also the water-soluble substance is easily dispersed while it shows the above preferred average particle diameter. Therefore, the types of the hydrophilic substance and the water-soluble substance are preferably selected according to the processing temperature of the used matrix material.

### Light transmitting member

The light transmitting member refers to a member for forming a portion having light transmission properties in part of the abrasive pad. A description is subsequently given of the light transmitting member with reference to the accompanying drawings.

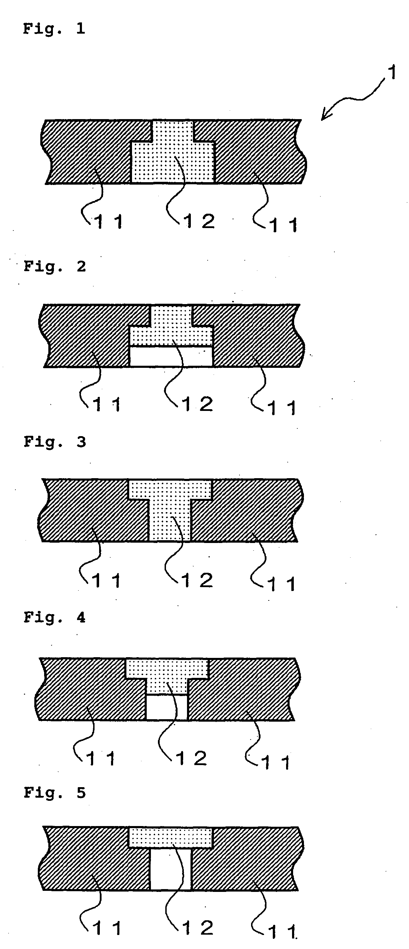

The shape of this light transmitting member is not particularly limited. The planar shape of the light transmitting member on the polishing surface side of the abrasive pad may be circular, elliptic, triangular, quadrilateral or polygonal. The sectional form perpendicular to the polishing surface of the light transmitting member is not particularly limited. Any shape is acceptable if light can be transmitted between the polishing surface side and the non-polishing surface side. For example, it may have sectional forms shown in Figs. 1 to 8. This light transmitting member 12 and the abrasive substrate 11 are fused together as an integrated unit.

The term "fused" refers to a state in which the light transmitting member and the abrasive substrate are bonded together by melting at least the bonding surf ace (s) of both or one of them without using an adhesive. For the production of the abrasive pad, not only the bonding surface but also the entire light transmitting member may be molten to be bonded, or the entire abrasive substrate may be molten to be bonded.

The method of fusing together the light transmitting member and the abrasive substrate is not particularly limited. For example, it may be (1) an insert molding method in which one of the light transmitting member and the abrasive substrate is held in a metal mold and the other member is injected and fused, (2) a method in which the light transmitting member and the abrasive substrate are manufactured in predetermined shapes and mated together, and their contact surfaces are molten to be bonded together by infrared welding, high-frequency welding, microwave welding or ultrasonic welding, or (3) a method in which a solvent is applied to the bonding surfaces of the light transmitting member and the abrasive substrate to bond them together.

Since the light transmitting member and the abrasive substrate of the abrasive pad of the present invention are fused together, there is no gap between the light transmitting member and the abrasive substrate, whereby slurry does not leak to the rear side of the abrasive pad.

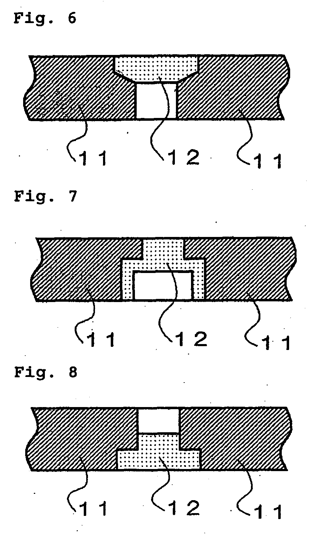

The thickness of this light transmitting member may not be smaller than the thickness of the abrasive substrate as shown in Figs. 1 and 3, may be smaller than the maximum thickness of the abrasive substrate as shown in Figs. 2, 4, 5, 6 and 8, or part of a light transmitting portion of the light transmitting member may be smaller in the thickness as shown in Fig. 7.

To transmit light through the light transmitting member, the intensity of the light attenuates in proportion to the square of the thickness of the light transmitting member. Therefore, by reducing the thickness of the light transmitting member, light transmission properties can be greatly improved. For example, even when it is difficult to obtain light having sufficiently high intensity for the detection of an end point from this light transmitting member which has the same thickness as other portions of the abrasive pad used for polishing making use of optical end-point detection, sufficiently high light intensity can be ensured for the detection of an end point by reducing the thickness of the light transmitting member. The thickness of the light transmitting member which has been made thin is preferably 0.1 mm or more, more preferably 0.2 mm to 4 mm, much more preferably 0.3 mm to 3 mm. When the thickness is smaller than 0.1 mm, it may be difficult to secure sufficiently high mechanical strength for the light transmitting member.

A depressed portion, where the light transmitting member is not existent, formed by reducing the thickness of the light transmitting member (for example, a portion below the light transmitting member 12 in Fig. 2) or a depressed portion of the light transmitting member (for example, a portion whose top, right and left sides are surrounded by the light transmitting member 12 in Fig. 7) may be formed on either one of the front and rear sides of the abrasive pad. When it is formed on the rear side of the abrasive pad, the thickness of the light transmitting member can be reduced without affecting polishing efficiency.

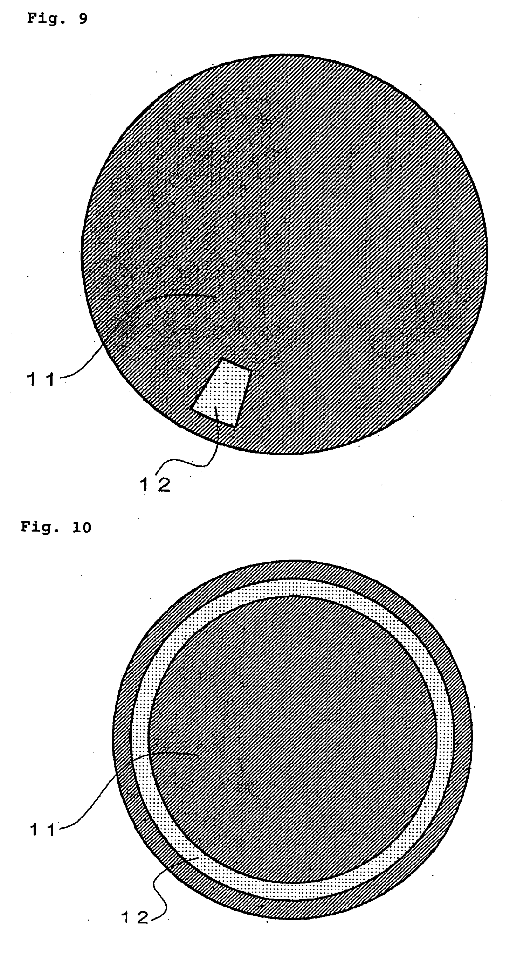

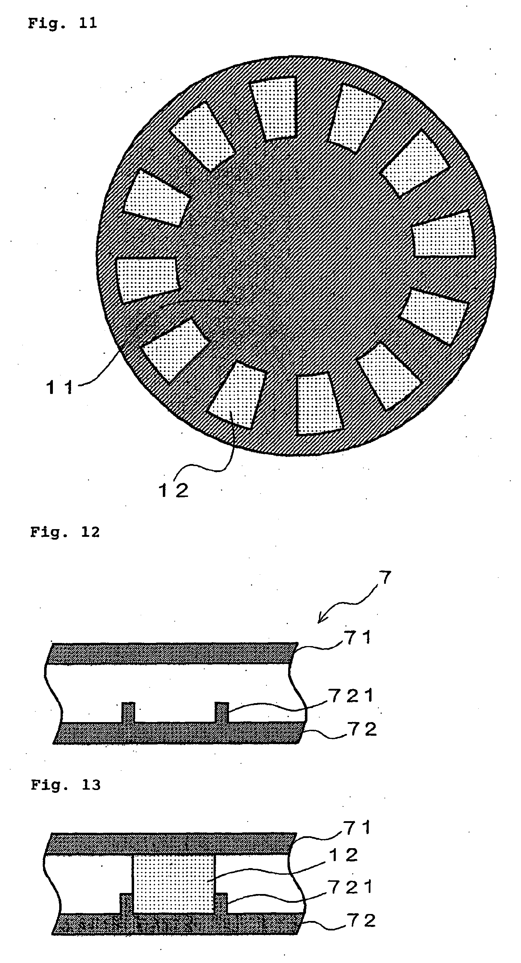

The number of the light transmitting members is not particularly limited and may be one or more. The position of the light transmitting member is not particularly limited. For example, when the abrasive pad has one light transmitting member, it may be arranged as shown in the plan views of Fig. 9 and Fig. 10. Further, when the abrasive pad has two or more light transmitting members, they may be arranged concentric to one another as shown in the plan view of Fig. 11.

As for the light transmission properties of the light transmitting member, when the thickness of the light transmitting member is 2 mm, it preferably has a transmittance at a wavelength between 100 and 3,000 nm of 0.1 % or more or an integrated transmittance at a wavelength between 100 to 3,000 nm of 0.1 % or more. This transmittance or integrated transmittance is more preferably 1 % or more, much more preferably 2 % or more, particularly preferably 3 **%** or more, ideally 4 % or more. The transmittance or integrated transmittance does not need to be higher than required, and may be 50 % or less, preferably 30 % or less, particularly preferably 20 % or less.

In the abrasive pad used for polishing using an optical end-point detection device, the light transmitting member preferably has a high transmittance at a wavelength range of 400 to 800 nm which is frequently used as light for end point detection. Therefore, it is preferable that a transmittance at a wavelength between 400 and 800 nm satisfies the above requirements.

This transmittance is a value measured at each wavelength with an UL absorptiometer which can measure the absorbance of a 2 mm-thick specimen at a predetermined wavelength. The integrated transmittance can be obtained by integrating transmittances at a predetermined wavelength range measured similarly.

The "water-insoluble matrix material" (may be simply referred to as "matrix material" hereinafter) for forming the above light transmitting member is preferably a thermoplastic resin, thermosetting resin, elastomer, rubber or a combination thereof which can provide light transmission properties. Although this matrix material does not need to be transparent or semitransparent if it has light transmission properties (which does not mean that it transmits only visible light), it preferably has higher light transmission properties, more preferably transparency.

The thermoplastic resin, thermosetting resin, elastomer, rubber, etc. which can provide light transmission properties may be the same as those listed for the water-insoluble matrix material used in the above abrasive substrate. These matrix materials may be used in combination of two or more. Further, the water-insoluble matrix material may be a mixture of a polymer having a functional group and a polymer having no functional group as explained in detail for the above abrasive substrate.

Preferably, these matrix materials contain a hydrophilic substance having a functional group to improve its compatibility with the water-soluble substance, abrasive grains, aqueous medium, etc. as required. What are enumerated for the above abrasive substrate may be used as the hydrophilic substance.

These hydrophilic substances may be used in combination of two or more.

The matrix material may be a crosslinked polymer or non-crosslinked polymer. At least part of the matrix material is preferably a crosslinked polymer. For example, the matrix material is a mixture of two or more materials and at least part of at least one of the materials is a crosslinked polymer, or the matrix material is only one material and at least part of the material is a crosslinked polymer.

When at least part of the matrix material has a crosslinked structure, elastic recovery force can be provided to the matrix material. Therefore, it is possible to suppress displacement caused by shearing stress applied to the abrasive pad at the time of polishing and to prevent the pores from being filled by the plastic deformation of the matrix material when it is excessively stretched at the time of polishing and dressing. It is also possible to prevent the surface of the abrasive pad from being fluffed excessively. Consequently, the retainability of slurry at the time of polishing is high, the retainability of slurry is easily recovered by dressing, and further scratching can be prevented.

These crosslinked polymers are the same as those listed for the above abrasive substrate.

Out of these crosslinked polymers, crosslinked 1,2-polybutadiene is particularly preferred because it can provide sufficiently high light transmission properties, is stable to a strong acid or strong alkali contained in many kinds of slurry and further is rarely softened by water absorption. This crosslinked 1,2-polybutadiene may be blended with other rubber such as butadiene rubber or isoprene rubber. Further, 1,2-polybutadiene may be used alone as the matrix material.

The residual elongation after breakage (to be simply referred to as "residual elongation at break" hereinafter) of the matrix material at least part of which is a crosslinked polymer can be set to 100 % or less when a matrix material specimen is broken at 80°C in accordance with JIS K 6251. This means that the matrix material has a total distance between bench marks of the specimen after breakage which is 2 times or less the distance between the bench marks before breakage. This residual elongation at break is preferably 30 % or less, more preferably 10 % or less, much more preferably 5 % or less and 0 % or more. As the residual elongation at break is higher than 100 %, fine pieces scraped off from the surface of the abrasive pad or stretched at the time of polishing or surface renewal tend to fill the pores.

The term "residual elongation at break" is an elongation obtained by subtracting the distance between bench marks before the test from the total distance between each bench mark and the broken portion of the broken and divided specimen in a tensile test in which a dumbbell-shaped specimen No. 3 is broken at a tensile rate of 500 mm/min and a test temperature of 80°C in accordance with the "vulcanized rubber tensile test method" specified in JIS K 6251. The test temperature is 80°C as the temperature reached by slide contact at the time of actual polishing is about 80°C.

The water-soluble substance is dispersed in the light transmitting member. It is a substance capable of forming pores by its contact with an aqueous medium supplied from the outside at the time of polishing as described above.

The shape, size, content in the light transmitting member and material of the water-soluble substance are the same as the water-soluble substance described in detail for the above abrasive substrate.

Preferably, the water-soluble substance which is exposed to the surface of the light transmitting member dissolves or gels in water and the water-soluble substance which is contained in the light transmitting member without surfacing does not absorb moisture or gel in the abrasive pad. Therefore, an outer shell made of an epoxy resin, polyimide, polyamide or polysilicate for suppressing moisture absorption may be formed on at least part of the' outer surface of the water-soluble substance.

This water-soluble substance has the function of matching the indentation hardness of the light transmitting member with that of other portion of the abrasive pad in addition to the function of forming pores. The Shore D hardness of the entire abrasive pad is preferably 35 to 100 in order to increase pressure to be applied at the time of polishing, improve polishing rate and obtain high flatness. However, it is often difficult to obtain a desired Shore D hardness only from the matrix material. In this case, the shore D hardness can be increased to the same level as that of other portion of the abrasive pad by containing the water-soluble substance, besides the formation of pores. For this reason, the water-soluble substance is preferably a solid material capable of securing sufficiently high indentation hardness for the abrasive pad.

The method of dispersing the above hydrophilic substance and the water-soluble substance in the matrix material at the time of production may be the same as the method described for the above abrasive substrate.

A compatibilizing agent such as a homopolymer, block copolymer or random copolymer modified by an acid anhydride group, carboxyl group, hydroxyl group, epoxy group, oxazoline group or amino group, which is optionally added at the time of production to improve compatibility between the matrix material and the water-soluble substance and the dispersibility in the matrix material of the water-soluble substance, a nonionic surfactant and a coupling agent may be contained, in addition to the matrix material and the water-soluble substance.

At least one selected from an abrasive grain, oxidizing agent, polyvalent metal ion, organic acid, hydroxide or acid of an alkali metal, pH modifier, surfactant and scratch prevention agent all of which have been contained in slurry may be contained in the abrasive pad of the present invention, that is, the light transmitting member and the abrasive pad substrate, in addition to the matrix material and the water-soluble substance. Thereby, when this abrasive pad is used, polishing can be carried out by supplying only water. Further, to the abrasive pad of the present invention may be optionally added additives such as a filler, softening agent, antioxidant, ultraviolet light absorber, antistatic agent, lubricant and plasticizer in limits that do not impair the effect of the present invention.

Examples of the above abrasive grain include inorganic particles such as silica particle, alumina particle, ceria particle, zirconia particle and titania particle, organic particles such as polystyrene, and organic/inorganic composite particles such as polystyrene/silica.

The above oxidizing agent is not particularly limited if it is water-soluble. Examples of the oxidizing agent include organic peroxides such as hydrogen peroxide, peracetic acid, perbenzoic acid and tert-butyl hydroperoxide, permanganic acid compounds such as potassium permanganate, bichromic acid compounds such as potassium bichromate, halogen acid compounds such as potassium iodate, nitric acid compounds such as nitric acid and iron nitrate, perhalogen acid compounds such as perchloric acid, transition metal salts such as potassium ferricyanide, persulfuric acid salts such as ammonium persulfate, salts of a polyvalent metal such as iron nitrate and cerium ammonium nitrate, and heteropoly-acids such as tungstosilicic acid, tungstophosphoric acid, molybdosilicic acid and molybdophosphoric acid. They may be used alone or in combination of two or more. Out of these, hydrogen peroxide and organic peroxides are particularly preferred because they do not contain any elemental metal and their decomposed products are harmless. By containing any one of these oxidizing agents, the polishing rate can be greatly improved when a metal layer such as a film to be processed of a wafer is polished.

The content of the oxidizing agent may be 0 to 10 parts by mass (may be simply referred to as "parts" hereinafter), particularly preferably 0 to 5 parts by mass based on 100 parts by mass of the whole pad as far as the effect of the present invention is not impaired.

Examples of the above polyvalent metal ion include ions of metals such as aluminum, titanium, vanadium, chromium, manganese, iron, cobalt, nickel, copper, zinc, germanium, zirconium, molybdenum, tin, antimony, tantalum, tungsten, lead and cerium. They may be used alone or in combination of two or more. The polyvalent metal ion is preferably an ion of at least one metal selected from aluminum, titanium, chromium, manganese, iron, copper, zinc, tin and cerium because a high polishing rate can be obtained. Out of these, iron ion and copper ion are particularly preferred. One or more out of nitrates, sulfates, acetates and gluconates of aluminum, nitrates, sulfates, acetates and gluconates of iron (III), and nitrates, sulfates, acetates and gluconates of copper (II) may be used as the metal salt(s) constituting the above polyvalent metal ion. These iron nitrates (III) also serve as an oxidizing agent. The content of the polyvalent metal ion in the whole pad is 0 to 10 % by mass, particularly preferably 0 to 5 % by mass.

The above organic acid can stabilize the above oxidizing agent and further improve the polishing rate. Preferred examples of the organic acid include paratoluenesulfonic acid, dodecylbenzenesulfonic acid, isoprenesulfnoic acid, gluconic acid, lactic acid, citric acid, tartaric acid, malic acid, glycolic acid, malonic acid, formic acid, oxalic acid, succinic acid, fumaric acid, maleic acid and phthalic acid. Out of these, gluconic acid, lactic acid, citric acid, tartaric acid, malic acid, glycolic acid, malonic acid, formic acid, oxalic acid, succinic acid, fumaric acid, maleic acid and phthalic acid are preferred. Particularly preferred are tartaric acid, malic acid, succinic acid and phthalic acid. These organic acids may be used alone or in combination of two or more. The content of the organic acid in the whole pad is preferably 0 to 10 % by mass, particularly preferably 0 to 5 % by mass.

The above surfactant may be cationic, anionic or nonionic. Examples of the cationic surfactant include aliphatic amine salts and aliphatic ammonium salts. Examples of the anionic surfactant include fatty acid soap, carboxylic acid salts such as alkyl ether carboxylates, sulfonic acid salts such as alkylbenzenesulfonates, alkylnaphthalenesulfonates and α-olefinsulfonates, sulfuric acid ester salts such as higher alcohol sulfuric acid ester salts, alkyl ether sulfates and polyoxyethylene alkylphenyl ethers, and phosphoric acid ester salts such as alkyl phosphates. Examples of the nonionic surfactant include ethers such as polyoxyethylene alkyl ethers, ether esters such as polyoxyethylene ethers of a glycerin ester, and esters such as polyethylene glycol fatty esters, glycerin esters and sorbitan esters. The content of the surfactant in the whole pad is preferably 0 to 10 % by mass, particularly preferably 0 to 5 % by mass.

Examples of the above filler include materials which improve stiffness, such as calcium carbonate, magnesium carbonate, talc and clay, and materials having a polishing effect such as manganese dioxide, manganese trioxide and barium carbonate.

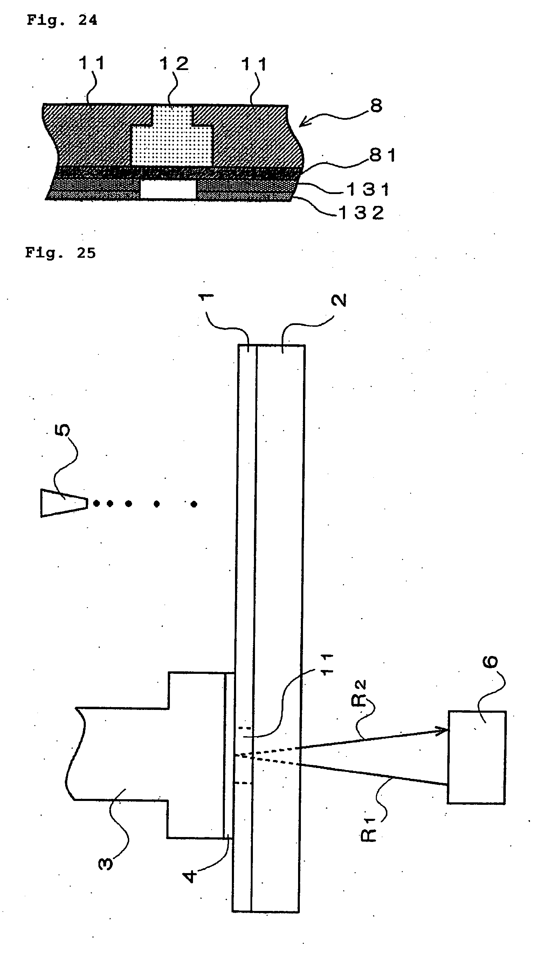

The abrasive pad of the present invention may have a fixing layer 13 for fixing the abrasive pad on a polishing machine for polishing on the rear surface opposite to the polishing surface as shown in Fig. 22. The fixing layer is not particularly limited if it can fix the abrasive pad itself.

This fixing layer may be a layer consisting of a layer formed by using an adhesive double-coated tape, for example, an adhesive layer 131 and a peel layer 132 formed on the outer surface of the adhesive layer 131, or an adhesive layer 131 formed by applying an adhesive. The peel layer 132 may be formed on the outer surface of the adhesive layer formed by applying an adhesive.

The adhesive material for forming the fixing layer is not particularly limited. It is, for example, a thermoplastic, thermosetting or photo curable acrylic adhesive or synthetic rubber adhesive. Commercially available products of the adhesive material include #442 of 3M Limited and #5511 and #5516 of Sekisui Chemical Co., Ltd.

Out of these fixing layers, a layer formed by using an adhesive double-coated tape is preferred because it has a peel layer in advance. A fixing layer having a peel layer can protect an adhesive layer before use and can easily fix the abrasive pad on the polishing machine by removing the peel layer at the time of use.

The light transmission properties of the material of the fixing layer are not particularly limited. When the material of the fixing layer does not have light transmission properties or has low light transmission properties, a through hole may be formed at a position corresponding to the light transmitting member. This through hole may be larger or smaller than or the same as the area of the light transmitting member.

It is preferred that a fixing layer should not be formed in the path of transmitted light when a through hole is formed in the fixing layer.

Further, when a fixing layer is formed by using an adhesive double-coated tape, a through hole can be formed at a predetermined position of the adhesive double-coated tape. The method of forming this through hole is not particularly limited. The through hole may be formed with a laser cutter or punching blade. When a laser cutter is used, the through hole may be formed after a fixing layer is formed by using an adhesive double-coated tape.

The above additives which have been contained in slurry may be contained in the whole abrasive pad of the present invention, particularly its abrasive substrate or light transmitting member. Other additives may further be contained. A groove or dot pattern may be formed on the polishing surface in a predetermined shape.

The planar shape of the abrasive pad is not particularly limited and may be circular (disk-like) or polygonal such as quadrilateral (belt-like, roller-like). The size of the abrasive pad is not particularly limited but may be 500 to 900 mm in diameter when it is disk-shaped.

The method of manufacturing the abrasive pad of the present invention is not particularly limited but the abrasive pad of the present invention may be manufactured by using mainly the following metal mold for insert molding.

### Metal mold for insert molding

The metal mold for insert molding of the present invention has a projection portion(s) and/or a depressed portion (s) for positioning the light transmitting member or the abrasive substrate which is molded in advance.

The position, shape, size and number of the projection portions and/or depressed portions for positioning the light transmitting member or the abrasive substrate are not particularly limited if they can position the light transmitting member or the abrasive substrate.

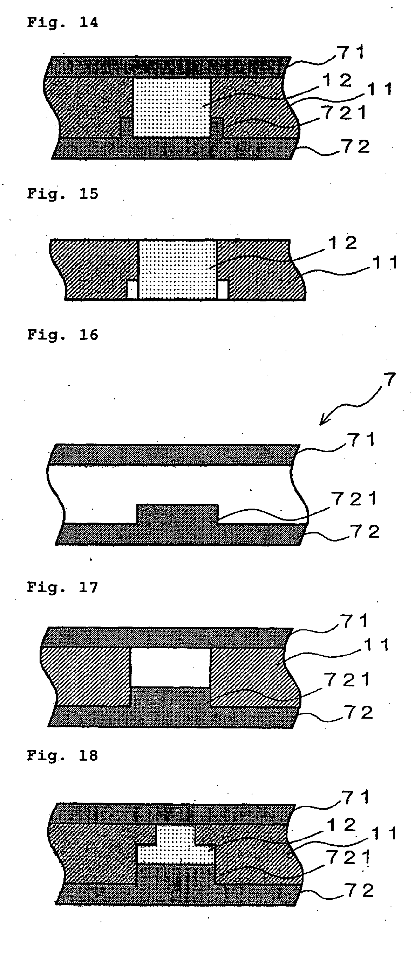

As for the projection portion(s) for positioning the light transmitting member, (1) a plurality of, for example, 3 or 4 dot-like, point-like or prolonged projections are arranged to surround the light transmitting member as shown in Fig. 12 and Fig. 13, (2) the above projections are each fitted in a depression formed in the center of the bottom of the light transmitting member, or (3) a ring-shaped projection, partially ring-shaped projection or quadrilateral projections, for example, prolonged projections are arranged to surround the light transmitting member in a ring-shaped or quadrilateral form so that they are mated with the light transmitting member having a circular bottom or quadrilateral bottom. As for the projection portion(s)for positioning the abrasive substrate, a disk-like or small quadrilateral pillar-like projection is fitted in a hole for accepting the light transmitting member in the abrasive substrate as shown in Fig. 16 and Fig. 17, or a dot-like, point-like or prolonged projection is fitted in a depression formed in the abrasive substrate.

Since the surface of the projection for fixing the abrasive substrate is a surface for forming the surface layer of the light transmitting member, the surface of the projection desirably has excellent flatness to improve the light transmission properties of the light transmitting member. It is particularly preferably a mirror finish surface.

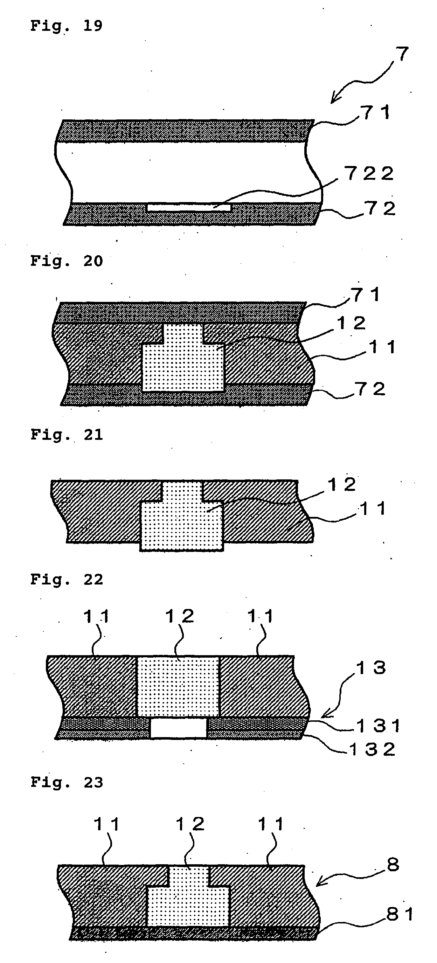

As for the depressed portion(s) for positioning the light transmitting member, as shown in Fig. 19 and Fig. 20, a circular or quadrilateral depression is formed to be mated with the light transmitting member, or depressions are arranged to be mated with dot-like, point-like or prolonged projections formed in the light transmitting member.

Further, as for the depressed portion(s) for positioning the abrasive substrate, depressions are arranged to be mated with dot-like, point-like and prolonged projections formed on the bottom portion of the abrasive substrate.

### Method of manufacturing abrasive pad

The method of manufacturing the abrasive pad of the present invention is not particularly limited if the light transmitting member or the abrasive substrate can be held in the metal mold and the material for forming the light transmitting member or the abrasive substrate can be injected into the cavity. To facilitate the manufacture of the abrasive pad of the present invention, the above metal mold for insert molding is preferably used.

This manufacturing method is mainly the following method (1) or (2).
(1) A dispersion is obtained by pre-kneading a matrix, a water-soluble substance and the like for forming the light transmitting member. The obtained dispersion is molded in a metal mold having a molding cavity to manufacture the light transmitting member.
   Then, this light transmitting member is set in a metal mold having a cavity and a dispersion for forming the abrasive substrate, obtained by kneading or the like, is injected and molded to obtain an abrasive pad.
   The above method (1) will be described in detail with reference to Fig. 13 to Fig. 15. The molded light transmitting member is held between the projection portions of the metal mold for insert molding having projection portions 721 for positioning as shown in Fig. 13. Thereafter, the metal mold 71 is fastened and the dispersion for forming the abrasive substrate, obtained by kneading or the like, is injected from an injection port (not shown) as understood from Fig. 14. This dispersion is solidified by cooling to mold an abrasive pad. Before the above metal mold is fastened, the dispersion for forming the abrasive substrate may be directly injected and then the above mold 71 may be fastened before molding.
   Thereby, an abrasive pad having a sectional form shown in Fig. 15 is obtained.
(2) An abrasive substrate having a hole for accepting the light transmitting member is first molded and then set in a metal mold having a cavity, a dispersion for forming the light transmitting member, obtained by kneading or the like, is injected into the hole of the abrasive substrate and molded in the metal mold to manufacture the light transmitting member, thereby obtaining an abrasive pad. The above hole may be a hole having a bottom or a through hole without a bottom. An abrasive substrate having a through hole is commonly used.
   The above method (2) will be described with reference to Fig. 17. An abrasive substrate molded in a predetermined shape is held onto the projection portion 721 of a metal mold for insert molding having a projection portion for positioning as shown in Fig. 17. Thereafter, the mold 71 is fastened and the dispersion for forming the abrasive substrate, obtained by kneading or the like, is injected from an injection port (not shown) to be molded. Before the above mold is fastened, the dispersion for forming the abrasive substrate may be directly injected and the above mold 71 may be fastened to mold it.
   The abrasive pad shown in Fig. 2 is thereby obtained.
   In the above methods (1) and (2), the inside temperature of the metal mold for insert molding is preferably 30 to 300°C, more preferably 40 to 250° C, much more preferably 50 to 200°C.
   The height of the light transmitting member and the thickness of the abrasive substrate do not need to be the same. Further, they may be processed to a desired thickness with abrasive paper, et al.
   By this insert molding method, abrasive pads having a complex sectional form as shown in Figs. 1 to 8 can be easily manufactured. The abrasive substrate and the light transmitting member can be firmly and easily bonded together.
   A groove or dot pattern may be formed in a predetermined shape on the polishing surface of the abrasive pad of the present invention as required in order to facilitate the discharge of the used slurry. When the groove or dot pattern is required, it can be obtained by forming a depression on the front side of the abrasive pad by reducing the thickness of the above light transmitting member.

### Abrasive laminated pad

The abrasive laminated pad of the present invention comprises the abrasive pad of the present invention and a base layer formed on the rear surface of the abrasive pad and has light transmission properties in the lamination direction.

The above "base layer" is a layer 81 formed on the rear surface opposite to the polishing surface of the abrasive pad as shown in Fig. 23. It doesn't matter whether the base layer has light transmission properties or not. For example, a base layer made of a material having the same or higher light transmission properties than the light transmitting member is used to secure light transmission properties for the abrasive laminated pad. In this case, a cut-away (through hole) may be or may not be formed. Further, when a base layer having no light transmission properties is used, the light transmission properties of the abrasive laminated pad can be secured by cutting away part of the base layer for transmitting light.

The shape of the base layer is not particularly limited and its planar shape may be quadrate, for example, quadrilateral, or circular. In general, it can be formed as a thin sheet. This base layer may be the same in planar shape as the abrasive pad. When it has a cut-away portion for securing light transmission, this portion is excluded.

The material for forming the base layer is not particularly limited and various materials may be used. An organic material is preferably used because it is easily molded to have a predetermined shape and predetermined properties and can be provided with suitable elasticity. The same materials as those used as the matrix material of the above-described light transmitting member may be used as this organic material. The material for forming the base layer may be the same or different from the matrix material (s) of the light transmitting member and/or the abrasive substrate.

The number of the base layers is not particularly limited and may be one or more. When two or more base layers are formed, they may be the same or different. The hardness of the base layer is not particularly limited but preferably lower than that of the abrasive pad. Thereby, the abrasive laminated pad has sufficiently high flexibility and suitable conformability to the unevenness of the surface to be polished as a whole.

The same fixing layers 131 and 132 as in the abrasive pad may be formed on the abrasive laminated pad of the present invention as shown in Fig. 24. They are generally formed on the rear surface of the base layer of the abrasive laminated pad, that is, the surface opposite to the polishing surface. They may be the same as that used in the above abrasive pad.

Further, the abrasive laminated pad is not limited to a particular shape and may be the same in shape and size as above.

### Method of polishing a semiconductor wafer

The method of polishing a semiconductor wafer of the present invention is to polish a semiconductor wafer with the abrasive pad or abrasive laminated pad of the present invention, using an optical end-point detection device for detecting the polishing end point of the semiconductor wafer.

The above "optical end-point detection device" is capable of detecting the polishing end point of the surface to be polished from light reflected from the surface of an object to be polished by transmitting light to the polishing surface through the light transmitting member from the rear surface side of the abrasive pad. Other measurement principles are not particularly limited.

In the method of polishing a semiconductor wafer of the present invention, the detection of an end point can be carried out without reducing polishing efficiency. For example, when the abrasive pad or the abrasive laminated pad is disk-shaped, light transmitting members are arranged in a loop and concentric to the center of the disk so that polishing can be carried out while the polishing end point is always monitored. Therefore, polishing can be ended surely at the optimal polishing end point.

In the method of polishing a semiconductor wafer of the present invention, a polishing machine shown in Fig. 25 may be used. That is, the machine comprises a rotatable base 2, a pressure head 3 which can turn and move in vertical and horizontal directions, a slurry feed unit 5 which can drop a predetermined amount per unit time of slurry on the base 2, and an optical end-point detection unit 6 installed below the base 2.

In this polishing machine, the abrasive pad (including the abrasive laminated pad) 1 of the present invention is fixed on the base 2, and the semiconductor wafer 4 is fixed to the lower end face of the pressure head 3 and pressed on the abrasive pad at a predetermined pressure. Slurry is dropped on the base 2 from the slurry feed unit 5 in a predetermined amount each time, and the base 2 and the pressure head 3 are turned to bring the semiconductor wafer in slide contact with the abrasive pad for polishing.

End-point detection radiation R₁ having a predetermined wavelength or wavelength range from the optical end-point detection unit 6 is applied to the surface to be polished of the semiconductor wafer 4 from the back of the base 2 through the light transmitting member 11 for polishing. That is, the base 2 itself has light transmission properties or the end-point detection radiation can be transmitted through a cut-away portion of the base 2. Reflected radiation R₂ obtained by reflecting this end-point detection radiation R₁ from the surface to be polished of the semiconductor wafer 4 is seized by the optical end-point detection unit 6 so that polishing can be carried out while the state of the surface to be polished is monitored from this reflected light.

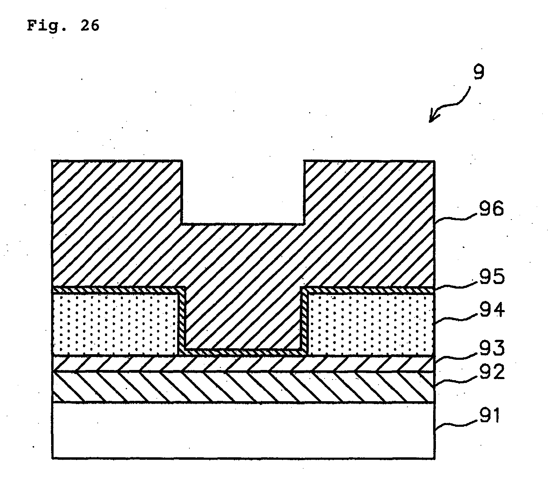

The suitable material to be polished by the polishing method of the present invention is, for example, a laminated substrate having a structure shown in Fig. 26. This laminated substrate comprises a substrate made of silicon et al, a first insulating film made of silicon oxide et al, a second insulating film having a groove (insulating material is selected from TEOS oxide film (silicon oxide-based insulating film prepared by a chemical vapor deposition method using tetraethoxysilane as raw material) insulating film having a low dielectric constant (such as silsequioxane, fluorine added SiO₂, polyimide-based resin, benzocyclobutene, etc.), etc.), a barrier metal film and a metal film as a wiring material (pure copper film, pure tungsten film, pure aluminum film, alloy film, etc.).

The object to be polished is, for example, an object to be polished including a buried material, or an object to be polished including no buried material.

The object to be polished including a buried material is, for example, a laminate which comprises a desired material deposited by CVD or the like so that the desired material is buried in at least the groove of a substrate which will become a semiconductor device (which generally comprises at least a wafer and an insulating film formed on the front surface of the wafer and may further comprise a stopper layer as a stopper for polishing formed on the insulating film) having a groove on at least its front surface. For the polishing of this object to be polished, after the buried material deposited excessively is removed by polishing with the abrasive pad of the present invention, the surface thereof can be polished to be flattened. When the object to be polished has a stopper layer under the buried material, the stopper layer may be polished in the latter stage at the same time.

The buried material is, for example, (1) an insulating material used in the STI (Shallow Trench Isolation) step, (2) at least one metal wiring material selected from A1 and Cu used in the damascene step, (3) at least one via plug material selected from W, A1 and Cu used in the step of forming a via plug, or (4) an insulating material used in the step of forming an interlayer insulating film.

The stopper material for forming the above stopper layer is a nitride-based material such as Si₃N₄, TaN or TiN, or a metal-based material such as tantalum, titanium or tungsten.

The above insulating material is a silicon oxide (SiO₂) film, a boron phosphorus silicate film (BPSG film) which comprises SiO₂ and small amounts of boron and phosphorus, an insulating film called "FSG (Fluorine doped Silicate Glass)" formed by doping SiO₂ with fluorine, or a silicon oxide-based insulating film having a small dielectric constant.

Examples of the silicon oxide film include a thermal oxide film, PETEOS film (Plasma Enhanced-TEOS film), HDP film (High Density Plasma Enhanced-TEOS film) and silicon oxide film obtained by thermal CVD.

The above thermal oxide film can be formed by exposing high-temperature silicon to an oxidizing atmosphere and chemically reacting silicon with oxygen or silicon with water.

The above PETEOS film can be formed from tetraethyl orthosilicate (TEOS) by CVD making use of plasma as accelerating means.

The above HDP film can be formed from tetraethyl orthosilicate (TEOS) by CVD making use of high-density plasma as accelerating means.

The above silicon oxide film obtained by thermal CVD can be obtained by normal-pressure CVD (AP-CVD) or low-pressure CVD (LP-CVD).

The above boron phosphorus silicate film (BPSG film) can be obtained by normal-pressure CVD (AP-CVD) or low-pressure CVD (LP-CVD).

The above insulating film called "FSG" can be formed by CVD making use of high-density plasma as an accelerator.

Further, the above silicon oxide-based insulating film having a small dielectric constant can be obtained by applying a raw material to a substrate by rotational coating or the like and heating it in an oxidizing atmosphere. Examples of the silicon oxide-based insulating film include an HSQ film (Hydrogen Silsequioxane film) made from triethoxysilane and MSQ film (Methyl Silsequioxane film) containing tetraethoxysilane and methyl trimethoxysilane as one of its raw materials.

Insulating films having a small dielectric constant made from an organic polymer such as polyarylene-based polymer, polyarylene ether-based polymer, polyimide-based polymer or benzocyclobutene polymer are also included.

This flush type laminate is shown in Fig. 26. That is, the laminated substrate 9 comprises a substrate 91 made of silicon et al, an insulating film 92 made of silicon oxide et al formed on the silicon substrate 91, an insulating film 93 formed of silicon nitride et al formed on the insulating film 92, an insulating film 94 made of PTEOS (material synthesized from tetraethoxysilane by CVD) formed on the insulating film 93 to form a groove, a barrier metal film 95 made of tantalum et al formed to cover the insulating film 94 and the groove, and a film 96 (groove is formed on the surface which is uneven) made of a wiring material such as metal copper formed on the above barrier metal film 95 to fill the groove.

The object to be polished including no buried material is a substrate made of polysilicon, bare silicon et al.

### Examples

The following examples are provided to further illustrate the present invention.

### Example 1

### (1) manufacture of light transmitting member

97 vol% of 1,2-polybutadiene (JSR RB830 of JSR Corporation) and 3 vol% of β-cyclodextrin (Dexy Pearl β-100 of Bio Research Corporation of Yokohama) as a water-soluble substance were kneaded together by a kneader heated at 120° C. Thereafter, dicumyl peroxide (Percumyl D of NOF Corporation) was added to the kneaded product in an amount of 0.8 part by mass based on 100 parts by mass of the total of 1,2-polybutadiene and β-cyclodextrin and further kneaded, a crosslinking reaction was carried out in a press mold at 170°C for 20 minutes to mold the kneaded product, and the molded product was cut to obtain a light transmitting member measuring 58 mm x 21 mm x 2.5 mm.

### (2) kneading of abrasive substrate material

80 vol% of 1,2-polybutadiene (JSR RB830 of JSR Corporation) which would be crosslinked later to become a matrix material and 20 vol% of β-cyclodextrin (Dexy Pearl β-100 of Bio Research Corporation of Yokohama) as a water-soluble substance were kneaded together by a kneader heated at 120°C. Thereafter, dicumyl peroxide (Percumyl D of NOF Corporation) was added to the kneaded product in an amount of 0.8 part by mass based on 100 parts by mass of the total of 1,2-polybutadiene and β-cyclodextrin and further kneaded.

### (3) manufacture of abrasive pad

The light transmitting member obtained in (1) above was set between the projection portions (721) of a metal mold for insert molding as shown in Fig. 13, the remaining space in the cavity of the above metal mold was filled with the abrasive substrate material kneaded in (2) above, the metal mold (71) was fastened, and a crosslinking reaction was carried out at 170°C for 20 minutes to mold a disk-like abrasive pad having a diameter of 60 cm and a thickness of 2.5 mm.

### (4) evaluation of abrasive pad

The abrasive pad manufactured as described above had a Shore D hardness of 70 and a tensile residual elongation of 2 %.

This abrasive pad was mounted on the base of a polishing machine to polish a thermal oxide film water at a base revolution of 50 rpm and a slurry flow rate of 100 cc/min. When the polishing rate was measured, it was 980 Å/min.

The light transmitting member obtained in the above Example (1) was measured for its transmittance at a wavelength of 650 nm with a UV absorptiometer (U-2010 of Hitachi, Ltd.). As a result, the average integrated transmittance of 5 times of measurement was 30 %.

### Comparative Example 1

80 vol% of 1,2-polybutadiene (JSR RB830 of JSR Corporation) which would be crosslinked later to become a matrix material and 20 vol% of β-cyclodextrin (Dexy Pearl β-100 of Bio Research Corporation of Yokohama) as a water-soluble substance were kneaded together by a kneader heated at 120° C. Thereafter, dicumyl peroxide (Percumyl D of NOF Corporation) was added to the kneaded product in an amount of 0.8 part by mass based on 100 parts by mass of the total of 1,2-polybutadiene and β-cyclodextrin and further kneaded, and a crosslinking reaction was carried out in a press mold at **170°** C for 20 minutes to mold a disk-like abrasive pad having a diameter of 60 cm and a thickness of 2.5 mm.

This polishing rate of this abrasive pad was 1,010 Å/min.

### Comparative Example 2

A commercially available foamed polyurethane abrasive pad (IC1010 of Rodel Co., Ltd.; Rohm and Haas Electronic Materials) having no light transmission properties was designated as Comparative Example 2. The polishing rate of this abrasive pad was 950 Å/min.

It can be understood from comparison between the polishing rate of Comparative Examples 1 and 2 and the polishing rate of Example 1 that the abrasive pad of the present invention is by no means inferior to an abrasive pad having no light transmitting member in polishing rate.

Since the light transmitting member and the abrasive substrate are fused together in the abrasive pad of the present invention, slurry does not leak to the rear side of the abrasive pad while the abrasive pad is used and the optical end-point detection unit (6) shown in Fig. 25 is not contaminated.

### Example 2

### (1) manufacture of light transmitting member

95 vol% of 1,2-polybutadiene (JSR RB830 of JSR Corporation) and 5 vol% of β-cyclodextrin (Dexy Pearl β-100 of Bio Research Corporation of Yokohama) as a water-soluble substance were kneaded together by a kneader heated at 160°C. Thereafter, dicumyl peroxide (Percumyl D of NOF Corporation) was added to the kneaded product in an amount of 1.0 part by mass based on 100 parts by mass of the total of 1,2-polybutadiene and β-cyclodextrin and further kneaded, a crosslinking reaction was carried out in a press mold at 170°C for 20 minutes to mold the kneaded product, and the molded product was cut to obtain a light transmitting member measuring 58 mm x 21 mm x 2.5 mm.

### (2) kneading of abrasive substrate material

A mixture was prepared by dry blending 80 wt% of 1,2-polybutadiene (JSR RB830 of JSR Corporation) with 20 wt% of a styrene-butadiene elastomer (JSR TR2827 of JSR Corporation). 70 vol% of the mixture which would be crosslinked later to become a matrix material was kneaded with 30 vol% of β-cyclodextrin (Dexy Pearl β-100 of Bio Research Corporation of Yokohama) as a water-soluble substance by a double-screw extruder. Thereafter, dicumyl peroxide (Percumyl D of NOF Corporation) was added to the kneaded product in an amount of 0.8 part by mass based on 100 parts by mass of the total of 1,2-polybutadiene, styrene-butadiene elastomer and β-cyclodextrin and further kneaded.

### (3) manufacture of abrasive pad

The light transmitting member obtained in (1) above was set between the projection portions (721) of the metal mold for insert molding as shown in Fig. 13, and the remaining space in the cavity of the metal old was filled with the abrasive substrate material kneaded in (2) above. The metal mold (71) was fastened, and a crosslinking reaction was carried out at 170°C for 20 minutes to mold a disk-like abrasive pad having a diameter of 60 cm and a thickness of 2.5 mm.

### (4) evaluation of abrasive pad

The abrasive pad manufactured as described above had a Shore D hardness of 65 and a tensile residual elongation of 2 %.

### Example 3

A disk-like abrasive pad having a diameter of 60 cm and a thickness of 2.5 mm was obtained in the same manner as in Example 1 except that potassium sulfate (manufactured by Otsuka Chemical Co., Ltd.) was used in place of β-cyclodextrin.

This abrasive pad had a Shore D hardness of 68 and a tensile residual elongation of 2 %.

### Example 4

### (1) manufacture of abrasive pad substrate

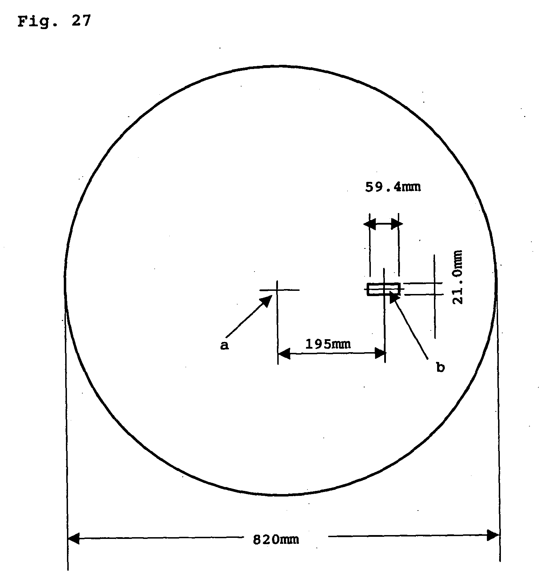

80 vol% of 1,2-polybutadiene (JSR RB830 of JSR Corporation) which would be crosslinked later to become a matrix material and 20 vol% of β-cyclodextrin (Dexy Pearl β-100 of Bio Research Corporation of Yokohama) as a water-soluble substance were kneaded together by a kneader heated at 120°C. Thereafter, dicumyl peroxide (Percumyl D of NOF Corporation) was added to the kneaded product in an amount of 0.8 part by mass based on 100 parts by mass of the total of 1,2-polybutadiene and β-cyclodextrin and further kneaded, and a crosslinking reaction was carried out in a press mold at 170°C for 10 minutes to obtain an abrasive substrate having a diameter of 820 mm. A 59.4 mm x 21.0 mm hole was made at a position 195 mm away from the center of the molded product as shown in Fig. 27. In Fig. 27, "a" is the central point of the abrasive pad substrate and "b" is the central point of the through hole formed to the central point of the abrasive pad substrate.

### (2) kneading of light transmitting member material

97 vol% of 1,2-polybutadiene (JSR RB830 of JSR Corporation) and 3 vol% of β-cyclodextrin (Dexy Pearl β-100 of Bio Research Corporation of Yokohama) as a water-soluble substance were kneaded together by a kneader heated at 120°C. Thereafter, dicumyl peroxide (Percumyl D of NOF Corporation) was added to the kneaded product in an amount of 0.8 part by mass based on 100 parts by mass of the total of 1,2-polybutadiene and β-cyclodextrin and further kneaded.

### (3) manufacture of abrasive pad

The abrasive pad substrate manufactured in (1) above was set onto the projection portion (721) of the metal mold for insert molding as shown in Fig. 17 to ensure that the hole of the abrasive substrate was situated at a position corresponding to the light transmitting member.

Further, the light transmitting member material kneaded in (2) above was injected into the space above the projection portion in the cavity of the metal mold, the metal mold (71) was fastened, and a crosslinking reaction was carried out at 170°C for 20 minutes to mold an abrasive pad having a diameter of 820 mm in which the rear surface of the light transmitting member was recessed from the rear surface of the abrasive substrate.

### (4) evaluation of abrasive pad

This abrasive pad had a Shore D hardness of 70 and a tensile residual elongation of 2 %.

### Example 5

### (1) manufacture of abrasive pad substrate

A mixture was prepared by dry blending 80 wt% of 1,2-polybutadiene (JSR RB830 of JSR Corporation) with 20 wt% of a styrene-butadiene elastomer (JSR TR2827 of JSR Corporation). 70 vol% of the mixture which would be crosslinked later to become a matrix material was kneaded with 30 vol% of β-cyclodextrin (Dexy Pearl β-100 of Bio Research Corporation of Yokohama) as a water-soluble substance by a double-screw extruder. Thereafter, dicumyl peroxide (Percumyl D of NOF Corporation) was added to the kneaded product in an amount of 0.8 part by mass based on 100 parts by mass of the total of 1,2-polybutadiene, styrene-butadiene elastomer and β-cyclodextrin and further kneaded, and a crosslinking reaction was carried out in a metal mold for insert molding having above light transmitting member at 170° C for 20 minutes to mold an abrasive substrate having a diameter of 820 mm. A 59.4 mm x 21.0 mm hole was made at a position 195 mm away from the center of the molded product as shown in Fig. 27.

### (2) kneading of light transmitting member material

97 vol% of 1,2-polybutadiene (JSR RB830 of JSR Corporation) and 3 vol% of β-cyclodextrin (Dexy Pearl β-100 of Bio Research Corporation of Yokohama) as a water-soluble substance were kneaded together by a kneader heated at 120° C. Thereafter, dicumyl peroxide (Percumyl D of NOF Corporation) was added to the kneaded product in an amount of 0.8 part by mass based on 100 parts by mass of the total of 1,2-polybutadiene and β-cyclodextrin and further kneaded.

### (3) manufacture of abrasive pad

The abrasive pad substrate manufactured in (1) above was set onto the projection portion (721) of the metal mold for insert molding as shown in Fig. 17 to ensure that the hole of the abrasive substrate manufactured in (1) above was situated at a position corresponding to the light transmitting member.

Further, the light transmitting member material kneaded in (2) above was injected into the space above the projection portion in the cavity of the metal mold, the metal mold (71) was fastened, and a crosslinking reaction was carried out at 170° C for 20 minutes to mold an abrasive pad having a diameter of 820 mm in which the rear surface of the light transmitting member was recessed from the rear surface of the abrasive substrate.

### (4) evaluation of abrasive pad

This abrasive pad had a Shore D hardness of 70 and a tensile residual elongation of 2 %.

### Example 6

After an abrasive pad was manufactured in the same manner as in Example 5, a double-tuck tape (Double Tuck Tape #512 of Sekisui Chemical Co., Ltd.) essentially composed of foamed polyethylene was formed as a base layer on the non-polishing side of the abrasive pad. Further, a 60 mm x 23 mm through hole was made in the base layer at a position corresponding to the light transmitting member to secure light transmission properties.

### Example 7

### (1) manufacture of abrasive pad substrate

A mixture was prepared by dry blending 70 wt% of 1,2-polybutadiene (JSR RB830 of JSR Corporation) with 30 wt% of commercially available polystyrene (HF55 of PS Japan Co. , Ltd.). 95 vol% of the mixture which would be crosslinked later to become a matrix material was kneaded with 5 vol% of β-cyclodextrin (Dexy Pearl β-100 of Bio Research Corporation of Yokohama) as a water-soluble substance by a double-screw extruder. Thereafter, dicumyl peroxide (Percumyl D40 of NOF Corporation) was added to the kneaded product in an amount of 0.4 part by mass based on 100 parts by mass of the total of 1,2-polybutadiene, polystyrene and β-cyclodextrin and further kneaded, and a crosslinking reaction was carried out in a metal mold for insert molding having above light transmitting member at 170°C for 10 minutes to mold an abrasive substrate having a diameter of 820 mm. A 59.4 mm x 21.0 mm rectangular hole was made at a position 195 mm away from the center of the molded product as shown in Fig. 27.

### (2) kneading of light transmitting member material

98 volt of 1,2-polybutadiene (JSR RB830 of JSR Corporation) which would be crosslinked later to become a matrix material and 2 vol% of β-cyclodextrin (Dexy Pearl β-100 of Bio Research Corporation of Yokohama) as a water-soluble substance were kneaded together by a double-screw extruder heated at 160° C. Thereafter, dicumyl peroxide (Percumyl D40 of NOF Corporation) was added to the kneaded product in an amount of 0.3 part by mass based on 100 parts by mass of the total of 1,2-polybutadiene and β-cyclodextrin and further kneaded.

### (3) manufacture of abrasive pad

The abrasive pad substrate manufactured in (1) above was set onto the projection portion (721) of the metal mold for insert molding as shown in Fig. 17 to ensure that the hole of the abrasive substrate manufactured in (1) above was situated at a position corresponding to the light transmitting member.

Further, the light transmitting member material kneaded in (2) above was injected into the space above the projection portion in the cavity of the metal mold. The metal mold (71) was then fastened, and a crosslinking reaction was carried out at 170°C for 18 minutes to mold an abrasive pad having a diameter of 820 mm in which the rear surface of the light transmitting member was recessed from the rear surface of the abrasive pad substrate.

The top surface of the projection portion (721) of the metal mold used in this example was a mirror finish surface.

### (4) evaluation of abrasive pad

This abrasive pad had a Shore D hardness of 65 and a tensile residual elongation of 2 %.

As described above, optical end-point detection can be carried out without reducing polishing efficiency when the abrasive pad of the present invention is used. Not only the polishing end point but also all the polishing states can be optically monitored. During the use of the abrasive pad, slurry does not leak to the rear side of the abrasive pad.

When at least part of the water-insoluble matrix material of the light transmitting member is a crosslinked polymer, it is possible to prevent pores from being filled at the time of polishing and dressing. It is also possible to prevent the surface of the abrasive pad from being fluffed excessively. Therefore, the retainability of the slurry is high at the time of polishing, the retainability of the slurry can be easily recovered by dressing, and scratching can be prevented.

When the crosslinked polymer for forming the light transmitting member is crosslinked 1,2-polybutadiene, the above effect can be fully obtained and sufficiently high light transmission properties can be obtained by containing the above crosslinked polymer. The crosslinked 1, 2 -polybutadiene is stable to a strong acid or strong alkali contained in many kinds of slurry and further has excellent durability as it is rarely softened by water absorption.

By reducing the thickness of the light transmitting member, light transmission properties can be improved. When the materials for forming the light transmitting member and the abrasive substrate are different in type or when they are the same in type but different in ratio, as the materials for forming the light transmitting member can be changed, it is possible to improve the light transmission properties of the light transmitting member as required.

Further, with the method of manufacturing an abrasive pad of the present invention, an abrasive pad having a complex shape can be easily manufactured because a light transmitting member and an abrasive substrate are manufactured as an integrated unit by using a metal mold and slurry does not leak to the rear side because the light transmitting member and the abrasive substrate are fused together.

The metal mold for insert molding of the present invention makes it easy to manufacture an abrasive pad comprising an abrasive substrate and a light transmitting member.

Optical end-point detection can be carried out without reducing polishing efficiency when the abrasive laminated pad of the present invention is used. Not only the polishing end point but also all the polishing states can be optically observed. The abrasive laminated pad has sufficiently high flexibility and suitable conformability to the unevenness of the surface to be polished.

Further, when the abrasive laminated pad has a fixing layer, it can be fixed on a polishing machine easily and quickly. Since it has light transmission properties, it does not impair the light transmission properties of the light transmitting member.

With the polishing method of the present invention, optical end-point detection can be carried out without reducing polishing efficiency.

An abrasive pad capable of transmitting light for end point detection without reducing polishing efficiency in the polishing of a semiconductor wafer using an optical end-point detection device, method of manufacturing the abrasive pad, a metal mold for manufacturing the abrasive pad, and a method of polishing a semiconductor wafer.

This abrasive pad comprises an abrasive substrate and a light transmitting member. The light transmitting member comprises a crosslinked polymer such as crosslinked 1,2-polybutadiene and a water-soluble substance such as β-cyclodextrin dispersed in the crosslinked polymer. Since the light transmitting member and the abrasive substrate are fused together as an integrated unit, slurry does not leak to the rear side of the abrasive pad during the abrasive pad used. This manufacturing method comprises setting the light transmitting member in the metal mold for insert molding and crosslinking a matrix dispersion for forming the abrasive substrate in this mold. The polishing method using this abrasive pad employs an optical end-point detection device.

## Claims

1. An abrasive pad comprising an abrasive substrate having a polishing surface and a light transmitting member which is fused to the abrasive substrate and comprises a water-insoluble matrix material and a water-soluble substance dispersed in the water-insoluble matrix material.

2. The abrasive pad of claim 1, wherein at least part of the water-insoluble matrix material is a crosslinked polymer.

3. The abrasive pad of claim 2, wherein the crosslinked polymer is crosslinked 1,2-polybutadiene.

4. The abrasive pad of claim 1, wherein the light transmitting member is made thin in a direction perpendicular to the polishing surface of the abrasive substrate.

5. The abrasive pad of claim 1, wherein the materials of the light transmitting material and the abrasive substrate differ from each other in type and/or ratio.

6. The abrasive pad of claim 1 which has a fixing layer for fixing the abrasive pad on a polishing machine, which is formed on the rear surface opposite to the polishing surface of the abrasive pad.

7. A method of manufacturing the abrasive pad of claim 1, comprising holding a previously formed light transmitting member for an abrasive pad at a predetermined position in the cavity of a metal mold for insert molding and injecting the material of an abrasive substrate into the remaining space in the cavity to fuse the light transmitting member to the abrasive substrate.

8. A method of manufacturing the polishing pad of claim 1, comprising holding a previously formed abrasive substrate having a hole for accepting a light transmitting member in the cavity of a metal mold for insert molding and injecting the material of the light transmitting member into the hole for accepting the light transmitting member to fuse the abrasive substrate to the light transmitting member.

9. A metal mold for insert molding for the manufacture of the abrasive pad of claim 1, which has a projection portion(s) and/or a depressed portion(s) for holding a light transmitting member or an abrasive substrate for an abrasive pad in a cavity.

10. An abrasive laminated pad comprising the abrasive pad of claim 1 and a base layer having light transmission properties formed on the rear surface opposite to the polishing surface of the abrasive pad.

11. An abrasive laminated pad comprising the abrasive pad of claim 1, a base layer formed on the rear surface opposite to the polishing surface of the abrasive pad, and a fixing layer for fixing the pad on a polishing machine, formed on the side opposite to the abrasive pad of the base layer.

12. A method of polishing a semiconductor wafer with an abrasive pad, **characterized in that** the abrasive pad of claim 1 or the abrasive laminated pad of claim 10 or 11 is used, and the polishing end point of the semiconductor wafer is detected by an optical end-point detection device through the light transmitting member of the abrasive pad or the abrasive laminated pad.
